(19) **Europäisches Patentamt**
**European Patent Office**
**Office européen des brevets**

(11) **EP 2 688 372 A1**

(12) **EUROPEAN PATENT APPLICATION**

(43) Date of publication:
**22.01.2014 Bulletin 2014/04**

(51) Int Cl.:
*H05B 41/285* (2006.01)     *H05B 37/02* (2006.01)
*H05B 41/36* (2006.01)

(21) Application number: **12305884.4**

(22) Date of filing: **20.07.2012**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Thomson Licensing**
**92130 Issy-les-Moulineaux (FR)**

(72) Inventors:
• **Louzir, Ali**
**35000 Rennes (FR)**
• **Le Naour, Jean-Yves**
**35740 Pace (FR)**

• **Robert, Jean-Luc**
**35830 Betton (FR)**

(74) Representative: **Rossmanith, Manfred**
**Deutsche Thomson OHG**
**European Patent Operations**
**Karl-Wiechert-Allee 74**
**30625 Hannover (DE)**

Remarks:
A request for correction of a reference in Fig. 1 has been filed pursuant to Rule 139 EPC. A decision on the request will be taken during the proceedings before the Examining Division (Guidelines for Examination in the EPO, A-V, 3.).

(54) **Apparatus and method for detecting fluorescent lighting**

(57)    The present invention suggests an apparatus for detecting the operation status of a fluorescent light source (101). The apparatus comprises an antenna for receiving (106) and sending (104) electromagnetic waves (107). The apparatus further comprises a modulation frequency correlator and a signal generator for generating an indication signal. According to a second aspect the present invention proposes a method for detecting the operation status of a fluorescent light source. The method comprises the steps of:
- receiving an electromagnetic wave;
- detecting a modulation of the received electromagnetic wave;
- correlating the modulation frequency of the received electromagnetic wave with a predetermined frequency;
- generating an indication signal if a correlation between the modulation frequency and the predetermined frequency is detected.

Fig.1

**Description**

Field of the invention

The invention is related to an apparatus and a method for detecting fluorescent lighting in a room. In particular, the present invention is related to apparatus according to claim 1 and a method according to claim 4.

Background of the invention

The deployment of sensor based systems offers many opportunities for providing new services and applications in the home. In particular, in the area of home networking, a Wi-Fi home gateway platform may include an interface with an advanced search and recommendation engine allowing home users to access their preferred or personalized content. In addition to that, background algorithms may utilize additional information which is collected in the home of the user to improve recommendations for media consumption or other purposes. Such kind of information includes e.g. time, date, and ambient temperature. It has been found useful to have information about the lighting in a room, if it is turned on or off. In the following this information is called operational status of the lighting. In conjunction with calendar and time information, the information about the status of lighting enables an adapted algorithm to provide more insight into the living habits inside a home.

Information about the operational status of the lighting is also an interesting information with regard to improving the management of power consumption in homes. In this context, there is an increasing demand for data about energy consuming devices. The lighting of rooms in homes and buildings is one factor that has to be taken into account in this general consideration. Energy disaggregation is a common keyword for this kind of research activities.

Combining the data collection in the home of a user with a residential gateway makes sense because the residential gateway provides an interface between a home network and a public network such as the Internet. The residential gateway comprises the full interaction between services and devices supported by the residential gateway which provides a number of additional enablers for supporting the home user. Multiple home devices are able to handle multiple media streams and the flows are directed to the most appropriate devices while other devices are informed about the incoming stream. Recording of media information is supported if needed. Thus, in the gateway there is already plenty of information available to generate recommendations to users with regard to media consumption. Consequently, it also makes sense for the gateway to capture context information such as information about the lighting in the home.

Modern gateways already support algorithms generating user recommendations based on a database about user preferences. Typically the database is built up over a long term. More advanced technologies also utilize the context information related to the user preferences and habits.

The context information includes e.g. the location of the user, activity, ambient temperature, lighting and others. Such kind of information can include for example at what time of the date the lighting is turned on and where.

Today the presence or absence of lighting is detected in consumer products with photo sensors, e.g. photodiodes or photovoltaic cells. A typical application is the detection of ambient light to adjust the brightness of a display.

Taking this as a starting point the present invention aims at an alternative approach for detecting fluorescent lighting.

Summary of the invention

According to a first aspect the present invention suggests an apparatus for detecting the operation status of a fluorescent light source. The apparatus comprises an antenna for receiving and sending electromagnetic waves. The apparatus further comprises a modulation frequency correlator and a signal generator for generating an indication signal.

An embodiment of the inventive apparatus comprises an amplitude detector which advantageously can be a narrowband amplitude detector.

Advantageously the apparatus can be communicatively coupled by the antenna to other wireless communication devices. In this case the coupling the apparatus and the other wireless communication devices can be accomplished by electromagnetic waves in the 2.4 GHz or 5 GHz band transmitted between the antenna and at least one antenna connected to the other wireless communication devices.

According to a second aspect the present invention suggests a method for detecting the operation status of a fluorescent light source, wherein the method comprises the following steps:

- receiving an electromagnetic wave;

  - detecting a modulation of the received electromagnetic wave;
  - correlating the modulation frequency of the received electromagnetic wave with a predetermined frequency;
  - generating an indication signal if a correlation between the modulation frequency and the predetermined frequency is detected.

Advantageously an embodiment of the inventive method can comprise further the step of utilizing the indication signal as an input information for and enhancing the functionality of consumer electronic devices.

The invention proposes a cost effective implementation of the method in any wireless device by direct coupling to existing radio modules. The invention exploits the interaction of electromagnetic waves with fluorescent light tubes or compact fluorescent light bulbs during the propagation of the electromagnetic wave. The interaction is based on the working principle of fluorescent lighting and gives rise to amplitude modulation of the electromagnetic wave at twice the frequency of the AC voltage supply and its harmonics. The presence absence of 100 Hz frequency harmonics in the received signal of the electromagnetic wave due to the interaction with fluorescent light is used as an indicator of the operation status of the fluorescent lighting and enables to detect whether the lighting is on or off.

Brief description of the drawings

In the drawing, an embodiment of the present invention is shown. The same or similar components are labeled with same or similar reference numbers.

Figure 1 schematically illustrates a room with a fluorescent light tube, a residential gateway and a set-top box;
figure 2A and 2B show a simplified 2-ray propagation model of electromagnetic waves in the room of figure 1;
Figures 3A and 3B show the signal level of the received electromagnetic wave when the fluorescent light tube is ON or OFF, respectively;
figures 4A and 4B show the signal level of a received electromagnetic wave when a compact fluorescent light bulb is ON or OFF, respectively;
figure 5 shows a schematic block diagram of the residential gateway of figure 1; and
figure 6 shows a schematic block diagram of a modulation detector included in the residential gateway of figure 5.

Detailed description

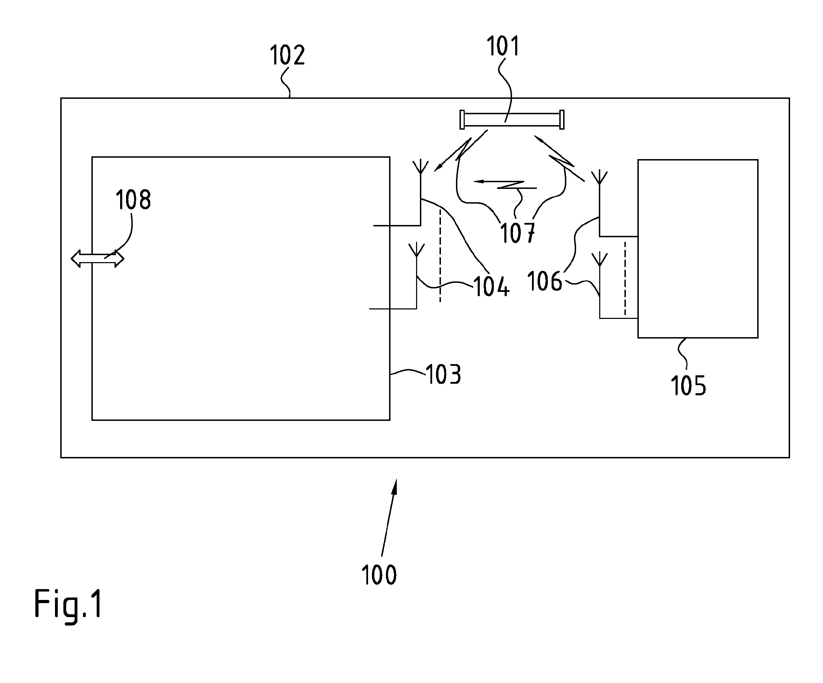

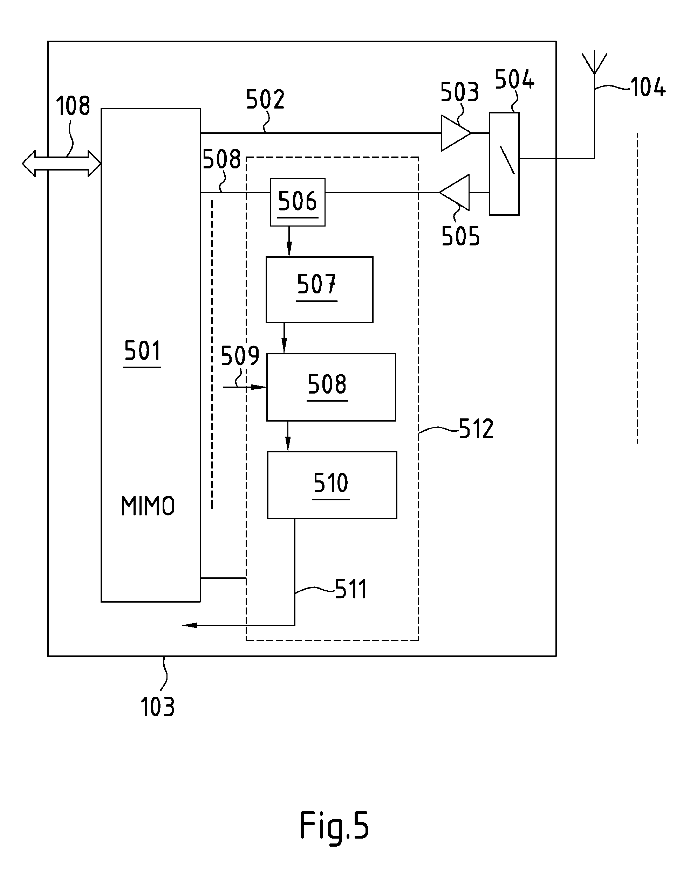

Figure 1 schematically illustrates a room 100. A fluorescent light tube 101 is mounted on the ceiling 102 of the room 100. In the room 100 there is also a gateway device 103 providing an access point to external networks such as PSTN, cable TV, and Internet. The access to external networks is symbolized in figure 1 by the double-headed arrow 108. Further details of the gateway 103 will be described further below in connection with figure 5. The gateway device 103 is provided with several transmission antennas 104. In the room there is also a set-top box 105 which is also provided with several antennas 106. In figure 1 only two of the antennas 104 and 106, respectively, are shown. In other embodiments of the present invention the gateway device 103 and the set-top box 105 are provided with only one antenna each. The antennas 104 and 106 enable a wireless bi-directional communication between the gateway device 103 and the set-top box 105. This wireless communication is based on transmitted and received electromagnetic waves establishing wireless data communication between the devices. In figure 1 the electromagnetic waves are symbolized by arrows 107.

The fluorescent light tube 101 is filled with a gas at low-pressure, e.g. mercury vapor, argon, xenon, neon or krypton. The inner surface of the tube is coated with a fluorescent coating (not shown). The light tube 101 comprises at its ends two electrodes (not shown) made of coiled tungsten.

During operation of the light tube 101 the electrodes are heated and emit free electrons into the gas filled inner volume of the light tube 101. Once the electrons have left the electrodes into the inner volume of the light tube 101, an electric field generated by a voltage applied between the two electrodes accelerates the electrons. The electrons travel with an increasing speed from the one electrode to the other electrode until they collide with a gas atom inside the light tube. If an electron has accumulated sufficient energy to excite an atom, the atom emits invisible ultraviolet light. The ultraviolet light is absorbed by the coating which finally emits visible light.

The accelerating electric field is generated by the AC mains voltage and therefore fluctuates at the mains frequency, e.g. 50 Hz in Europe. It is noted, however, that the invention does not depend on the mains frequency. The specific value of 50 Hz has only exemplary character. During one full period of the AC mains supply voltage, the mains voltage takes on a positive and negative maximum value. At the same time the AC current flowing between the electrodes of the light tube 101 takes on two maximum values. But the two maximum currents flow in opposite directions in the light tube because of the reversal of the polarity of the mains supply voltage. The current is carried by the free electrons traveling inside the light tube 101. When the current through the light tube 101 is maximum then there is also a maximum number of electrons inside the light tube and at the same time there is maximum light emission. When the current through the light tube is minimum then there is a minimum number of electrons inside the light tube 101 and there is minimum light emission. In consequence, the light emission fluctuates at a frequency of 100 Hz between the maximum and minimum values in synchronism with the number of free electrons and current flow inside the light tube 101. In compliance with usual terminology, the number of free electrons in the gas volume is described as electron density.

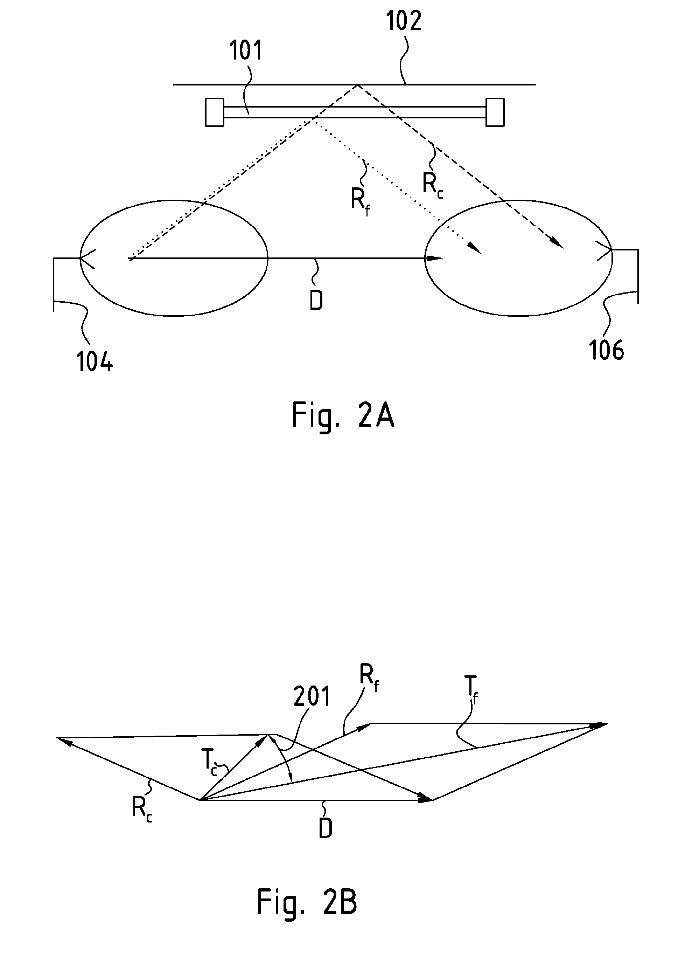

Electromagnetic waves impinging from the outside onto the light tube 101 will interact with an electron density inside the light tube 101 fluctuating at a frequency of 100 Hz between the maximum value and the minimum value. Consequently, the reflective properties of the light tube 101 for external electromagnetic waves change at the same frequency of 100 Hz from being a good reflector (reflective phase) to being almost transparent (transparent phase). The fluctuation of the reflective properties of the light tube 101 gives rise to an amplitude and phase modulation of electromagnetic waves impinging on the light tube 101. This will be explained in greater detail in conjunction with a simple 2-wave-propagation model which is laid out in figures 2A and 2B.

Figure 2A is a simplified representation of the room 100 of figure 1. In figure 2A only antennas 104 and 106 are shown from gateway 103 and set-top box 105, respectively. As shown in figure 2A, an electromagnetic wave propagates from transmitting antenna 104 to receiving antenna 106 using 2 different paths. There is a direct path indicated with an arrow D. There are also two indirect paths, namely an indirect path of the electromagnetic wave indicated by an arrow Rc. Along the path Rc, the electromagnetic wave is reflected at the ceiling of the room 100 when the light tube 101 is in its transparent phase. There is another indirect path of the electromagnetic wave indicated with an arrow Rf. Along the path Rf, the electromagnetic wave is reflected at the light tube 101 when it is in its reflective phase.

As it is illustrated in figure 2B by means of a vector diagram of the signal components mentioned in connection with figure 2A, the total received signal level of the electromagnetic wave is different for the reflective and the transparent phase of the light tube 101. In the transparent phase of the light tube 101, the total signal level is equal to

$$Tc=D+Rc$$

where D is the portion of the direct signal and Rc is the portion of the component reflected by the ceiling 102.

In the reflective phase of the light tube 101, the total signal level of the electromagnetic wave is equal to

$$Tf=D+Rf$$

where D is the portion of the direct signal and Rf is the portion of the component reflected by the light tube 101.

Thus, as shown in figure 2B and explained above, the level of the total received signal fluctuates in amplitude and phase between Tc and Tf values at the same rate as the fluorescent light, i.e. at 100 Hz. A double headed arrow 201 shows in the vector diagram the fluctuation between Tc and Tf. Moregenerally , D represents the total signal resulting from the combination of paths of the electromagnetic wave which do not interact with the fluorescent lighting. Rf and Rc represent the combination of paths having interacted with the fluorescent tube 101 either in its reflective or transparent phase.

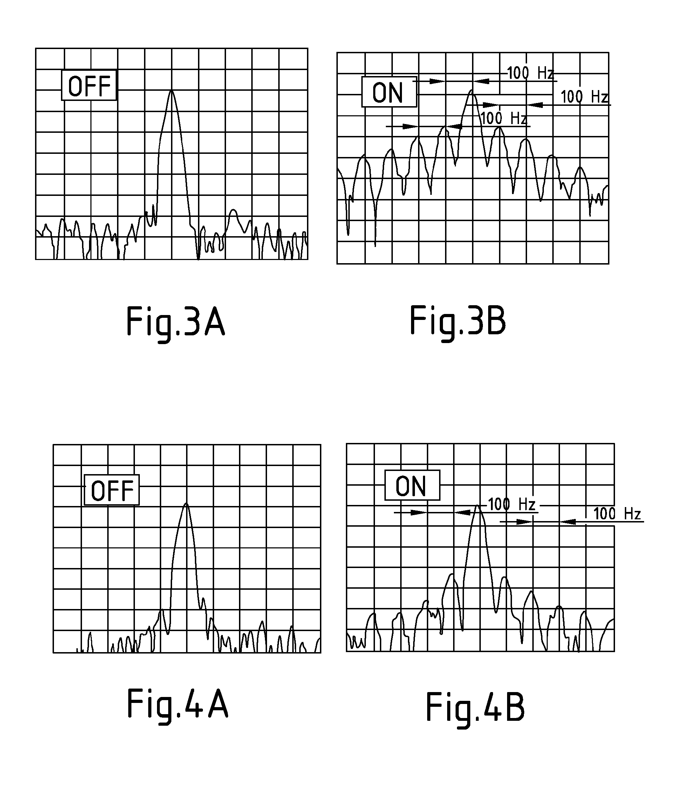

As shown in figure 3A and 3B, the described phenomenon is measurable with an electromagnetic wave at a frequency of 5 GHz. Figure 3A shows the received spectrum of the 5 GHz electromagnetic wave when the fluorescent lighting is off. In figure 3B the spectrum of the 5 GHz electromagnetic wave is shown when the fluorescent lighting is on. As can be clearly seen in figure 3B the signal level of the electromagnetic wave is modulated at a frequency of 100 Hz. One unit in horizontal direction in figures 3A and 3B corresponds to a frequency difference of 100 Hz. The maxima of the signal level signal are separated by 100 Hz. Similar results can be found with an electromagnetic wave having a frequency of 2.4 GHz.

The principles of the present invention work in the same way for elongated fluorescent light tubes and for compact fluorescent light tubes.

In figures 4A and 4B corresponding measurements are shown for compact fluorescent light bulbs. Again the modulation of the signal level at the frequency of 100 Hz is clearly visible.

For the sake of brevity, the invention is only described in connection with elongated fluorescent light tube.

The present invention will make use of this modulation of the signal level of the received signal in order to detect if the fluorescent lighting is in its on or off state in a room where electromagnetic waves are propagating.

Figure 5 shows the gateway 103 in greater detail. For the sake of simplicity only one antenna 104 is shown in figure 5. However, in other embodiments the gateway 103 is provided with a plurality of antennas.

The connection of the gateway to external networks is symbolized with arrow 108 interfacing with a MIMO device 501. One output 502 of the MIMO device 501 is connected with a power amplifier 503. By means of a selection switch 504, the power amplifier 503 is connected to the antenna 104 when the gateway 103 is in a sending mode. When the gateway 103 is in a receiving mode to receive electromagnetic waves (RF signal), then the selection switch 504 changes its state and connects the antenna 104 with a low noise amplifier 505. The output of the low noise amplifier 505 is provided to an RF coupler 506. The RF coupler 506 provides an output signal on the one hand to a narrow band amplitude detector 507 and on the other hand to an input 508 of the MIMO device 501. The MIMO device forwards the received input signal to perform conventional signal processing in the gateway 103. The narrow band amplitude detector 507 filters the electromagnetic wave which is received by the antenna 104. The output of the narrowband amplitude detector 507 is provided to a frequency correlator 508 which detects if there is a modulation of the received RF (radio frequency) signal which is correlated with a reference frequency signal. The reference frequency signal is generated from a frequency signal provided at input 509 of the frequency correlator 508. In the present embodiment of the invention, the reference frequency is the second harmonic of the mains AC frequency of 50 Hz, i.e. the reference frequency is 100 Hz. The frequency correlator 508 communicates an output signal to a signalization stage 510 which generates an indication signal if the frequency correlator 508 has detected that the RF signal level has a modulation which is correlated with the reference frequency. Then the signalization stage 510 produces an indication signal 511 for further usage in the gateway 103. The group of components comprising the RF coupler 506, the narrow band amplitude detector 507, the frequency correlator 508, and the signalization stage 510 form together a detection and signalization unit 512.

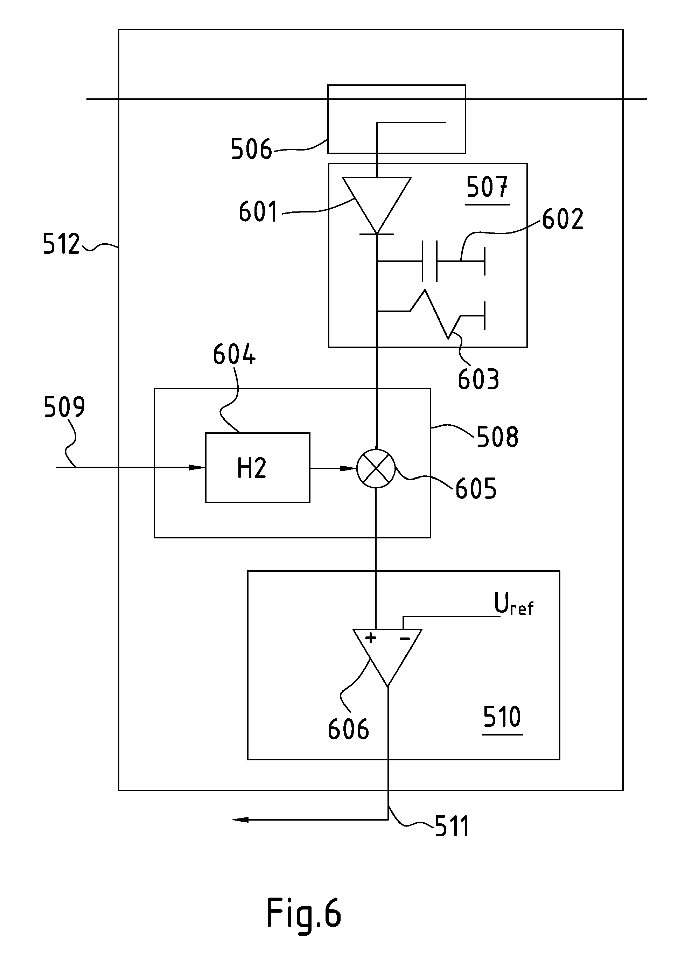

Figure 6 shows the detection and signalization unit 512 of figure 5 in greater detail. The RF signal received by the antenna 104 is coupled to the detection and signalization unit 512 by the RF coupler 506 and is provided to the narrowband detector 507. The structure of the narrowband detector 507 is known in the prior art and therefore only symbolically indicated by a diode 601, a capacitor 602 and an inductivity 603. The output signal of the narrowband detector 507 is connected with the frequency correlator 508 and forms a first input signal for the frequency correlator 508. The frequency correlator 508 receives as a second input signal a frequency signal 509 having the same frequency as the local mains frequency. In the present embodiment, the frequency signal has a frequency of 50 Hz and is used as input signal for a harmonics generator 604 generating the second harmonics of the frequency signal. The output of the harmonics generator 604 is the reference frequency signal having a frequency of 100 Hz. The 100 Hz reference frequency signal is provided to a mixer 605 where it is mixed with the output signal of the narrowband amplitude detector 507. The mixer 605 produces a DC output signal which varies as a function of the presence or absence of a 100 Hz signal modulation detected in the output signal of the narrowband amplitude detector 507. The output signal of the mixer 605 is provided as input signal to the signalization stage 510. In the signalization stage 510, this input signal is compared with a predetermined reference voltage Uref in a comparator 606. If the output signal of the mixer 605 exceeds a predetermined threshold value which is defined by Uref then the signalization stage 510 generates the indication signal 511 indicating that the presence of fluorescent lighting has been detected. This indication signal is used e.g. in recommendation algorithms as it has been described in the introduction of the present invention.

In countries having a mains frequency of 60 Hz the received signal level of the electromagnetic wave is modulated with a frequency of 120 Hz. Again, the modulation frequency is the second harmonic of the mains frequency.

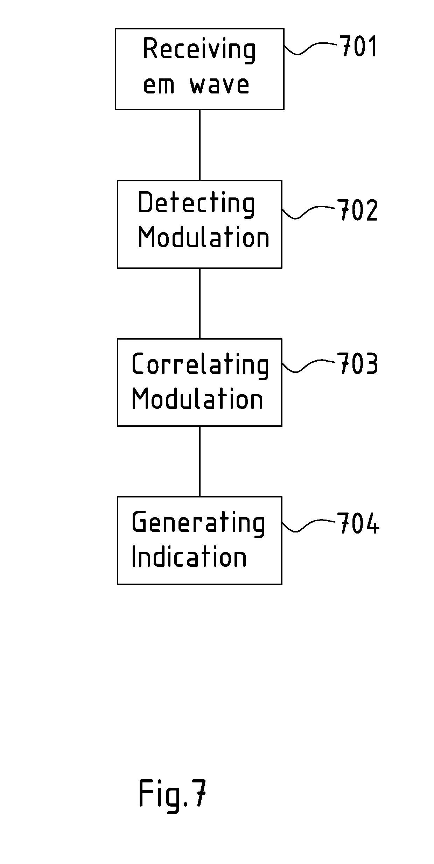

Figure 7 is a flow diagram illustrating the method according to the invention. In step 701 an electromagnetic wave is received. In step 702 it is detected if the electromagnetic wave is modulated and subsequently - if such modulation is found - the modulation frequency is correlated with the predetermined frequency in step 703. Finally, an indication signal is generated in step 704 if a correlation between the modulation frequency and the predetermined frequency is detected.

List of reference numbers

[0035]

| | |
|---|---|
| 100 | room |
| 101 | fluorescent light tube |
| 102 | ceiling |
| 103 | gateway device |
| 104 | antenna |
| 105 | set-top box |
| 106 | antenna |
| 107 | arrow (electromagnetic waves) |
| 108 | arrow (access to external networks) |
| 201 | double headed arrow (fluctuation between Tc and Tf) |
| 501 | MIMO device |
| 502 | output of MIMO device |
| 503 | power amplifier |
| 504 | selections switch |
| 505 | low noise amplifier |
| 506 | RF coupler |
| 507 | narrowband amplitude detector |
| 508 | frequency correlator |
| 509 | input of frequency correlator |
| 510 | signalization stage |
| 511 | indication signal |
| 512 | detection and signalization unit |
| 601 | diode |
| 602 | capacitor |
| 603 | inductivity |
| 604 | harmonics generator |
| 605 | mixer |
| 606 | comparator |
| 701 ... 704 | method steps |

**Claims**

1. Apparatus for detecting the operation status of a fluorescent light source (101), the apparatus comprising an antenna (104) for receiving and sending electromagnetic waves (107), a modulation frequency correlator (508) and a signal generator (510, 512) for generating an indication signal (511).

2. Apparatus according to claim 1, comprising an amplitude detector (507).

3. Apparatus according to claim 1, comprising a narrowband detector (507).

4. Apparatus according to one or several of the preceding claims, wherein the apparatus is communicatively coupled by the antenna (104) to other wireless communication devices (105).

5. Apparatus according to claim 4, wherein the coupling the apparatus and the other wireless communication devices (105) is accomplished by electromagnetic waves in the 2.4 GHz or 5 GHz band transmitted between the antenna (104) and at least one antenna (106) connected to the other wireless communication devices (105).

6. Method for detecting the operation status of a fluorescent light source, wherein the method comprises the following steps:

- receiving an electromagnetic wave (107);
- detecting a modulation of the received electromagnetic wave;
- correlating the modulation frequency of the received electromagnetic wave with a predetermined frequency;
- generating an indication signal (511) if a correlation between the modulation frequency and the predetermined frequency is detected.

7. Method according to claim 4 further comprising the step of utilizing the indication signal (511) as an input information for and enhancing the functionality of consumer electronic device (103, 104).

Fig.1

EP 2 688 372 A1

Fig. 2A

Fig. 2B

Fig.3A

Fig.3B

Fig.4A

Fig.4B

Fig.5

Fig.6

Receiving em wave — 701

Detecting Modulation — 702

Correlating Modulation — 703

Generating Indication — 704

Fig.7

Europäisches
Patentamt

European
Patent Office

Office européen
des brevets

# EUROPEAN SEARCH REPORT

Application Number

EP 12 30 5884

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/284169 A1 (VALOIS CHARLES BERNARD [US]) 19 November 2009 (2009-11-19) | 1,6 | INV.<br>H05B41/285<br>H05B37/02<br>H05B41/36 |
| A | * the whole document *<br>----- | 2-5,7 | |

TECHNICAL FIELDS
SEARCHED      (IPC)

H05B

The present search report has been drawn up for all claims

| Place of search | Date of completion of the search | Examiner |
|---|---|---|
| Munich | 30 November 2012 | Burchielli, M |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 12 30 5884

30-11-2012

| Patent document cited in search report | Publication date | Patent family member(s) | Publication date |
|---|---|---|---|
| US 2009284169 A1 | 19-11-2009 | US 2009284169 A1<br>US 2009284184 A1<br>US 2009284747 A1<br>US 2010084992 A1 | 19-11-2009<br>19-11-2009<br>19-11-2009<br>08-04-2010 |

EPO FORM P0459